(19) **Europäisches Patentamt / European Patent Office / Office européen des brevets**

(11) **EP 4 779 331 A1**

(12) # EUROPEAN PATENT APPLICATION
published in accordance with Art. 153(4) EPC

(43) Date of publication:
**22.07.2026 Bulletin 2026/30**

(21) Application number: **23952140.4**

(22) Date of filing: **13.09.2023**

(51) International Patent Classification (IPC):
*G01R 31/08* (2020.01)      *G01R 31/50* (2020.01)

(52) Cooperative Patent Classification (CPC):
**G01R 31/08; G01R 31/50**

(86) International application number:
**PCT/ES2023/070557**

(87) International publication number:
**WO 2025/056819 (20.03.2025 Gazette 2025/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Telefónica, S.A.**
**28013 Madrid (ES)**

(72) Inventors:
• **RAMÍREZ PÉREZ, Alberto José**
  **28013 MADRID (ES)**
• **RABADÁN BARROSO, Javier**
  **28013 MADRID (ES)**
• **TOCA GARCÍA, Manuel**
  **28013 MADRID (ES)**
• **PRIETO ANTÓN, Sergio**
  **28013 MADRID (ES)**

(74) Representative: **Herrero & Asociados, S.L.**
**Edificio Aqua - Calle Agustín de Foxá, 4-10, 2ºA**
**28036 Madrid (ES)**

(54) **ELECTROMAGNETIC DEVICE AND METHOD FOR VERIFYING CONTINUITY AND PRESSURE IN CONDUITS**

(57)    An electromagnetic marker device (beacon) and method that, through the use of this device, allows for rapid, accurate, repeatable, and auditable continuity and pressure verification tests in a conduit of ducts for a fiber optic network. The device connects to a duct in a fiber optic network conduit and incorporates a resonant circuit capable of resonating at two different frequencies depending on the pressure inside the duct to which the device is connected.

FIG. 7

**Description**

**Object of the invention**

The present invention is applied in the technical sector of fiber optic telecommunications and, in particular, presents a technical solution for carrying out pressure and continuity tests on network of buried ducts (e.g., microducts), by means of an electromagnetic device (beacon), which also allows the detection of the end of the buried microducts.

**Background of the invention**

Fiber optic data distribution networks are increasingly used to provide broadband data connections to users. In some scenarios, due to a lack of available infrastructure for laying new fiber optic cables, it is necessary to construct new conduits before deploying the fiber optic network. The construction of these new conduits often requires digging new trenches (civil works), which significantly increases deployment costs, and for this reason, the use of microducts is a clear trend to minimize trench size and, consequently, deployment costs. Microducts are tubes for transporting optical fiber, with dimensions much smaller than traditional ducts (typically between 5 and 20 mm in diameter).

It is also quite common that deployments in some countries are carried out without installing intermediate manholes or access points, or with a very limited number of them (for example, with the aim of minimizing costs, speeding up permits with the authorities, etc.). This means that in the future there will be no quick access to fiber optic conduit, making maintenance and operation difficult, as in many cases only the two ends of the duct are available/accessible.

Therefore, marking the conduit and recording its routing is particularly important, as it is necessary to know precisely where the conduit runs in case repairs are needed.

With this function, it is very common, for example, to use electromagnetic devices (called beacons because of their signaling function) buried at certain intervals along a conduit routing. Thanks to the placement of these devices, it is possible to detect where the conduit runs in the future using a simple beacon detector. It is also common to use this type of beacon to mark specific points in the fiber optic network (branches, splices, or connections, etc.). These beacons are not only used in telecommunications conduits, but also in other fields (water, energy, gas, sanitary pipelines, etc.).

The fiber optic network is called by different names depending on where the network ends, so we would have for example: fiber to the building (FTTB) or fiber to the home (FTTH).

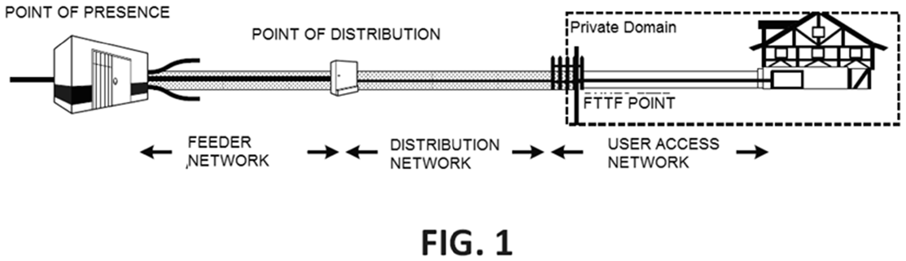

It is common for any new FTTH network to have different segments from the operator's central office (or point of presence) to customers' premises. Although this classification is not standardized, we could speak of three clearly differentiated sections: the feeder network, the distribution network, and the drop (or user access) network. The feeder network typically runs from a central office (or point of presence, POP) to a distribution point (DP). A distribution point can serve a certain number of properties (N), and therefore, it usually consolidates a number of connections on the distribution side, reducing them to a single cable or two to the feeder network. The distribution network is the section that runs from the distribution point (DP) to the final breakout of the service drop, which then becomes part of the drop or user access network. The drop or user access network, within the private domain of each home/property, runs from the final breakout performed from the distribution network (shared by several properties) to each home/property (dedicated drop). This can be clearly seen graphically in Figure 1, which shows a basic diagram of the FTTH network.

In fiber optic networks, the concept of homes passed is used, which are those homes (premises) covered by a provider's fiber optic network in a given area or, in other words, homes that can potentially be connected to the fiber optic network in an area, if their owners were to contract the service since the fiber optic network is deployed in that area. It is quite common, during the deployment phase (when talking about homes passed) that the section of the drop network (user access network) is not deployed, and that it is only done when the customer is fully connected, once the fiber optic service has been contracted (that is, when it is not simply a home passed by a provider's network but a home that has contracted the service of said provider and is connected to its network). In certain cases, a partial deployment of the service drop may be carried out to reduce future connection costs for each customer (when they wish to connect to the network). This type of partial deployment is commonly called Home Pass Plus (HP+) or also FTTF ("Fiber To The Fence"). These terms generally cover cases where fiber is brought to the fence, but also where the conduit (physical infrastructure of the fiber optic network) reaches the property fence. Figure 1 shows where the FTTF point would be located in the basic network diagram shown.

All network sections are inventoried and may be marked with electromagnetic beacons at the discretion of each operator. However, the specific points where future action is expected to be necessary are those where the use of electromagnetic beacons is most appropriate, as it is more likely that access to that point will be required in the future. One of the unique points that can be marked with electromagnetic markers (and is in fact common practice in the deployments of many operators in Europe) are the points where the customer service drop is broken-out from the distribution network, and also, more specifically, the point where the drop that will subsequently serve the property is buried (the FTTF or HP+ point).

The location of this point must be recorded with high precision and be easily locatable in the future, since when the property owner finally contracts the service, this point will be used as the starting point to continue the final section of the drop to the interior of the house. Given the importance of correctly locating these points, it is very common to record the exact location of the FTTF or HP+ point using GPS coordinates (usually requiring centimeter-level accuracy). It is also quite common to install an electromagnetic beacon at this point to allow location with a simple beacon detector, instead of requiring a high-precision GPS.

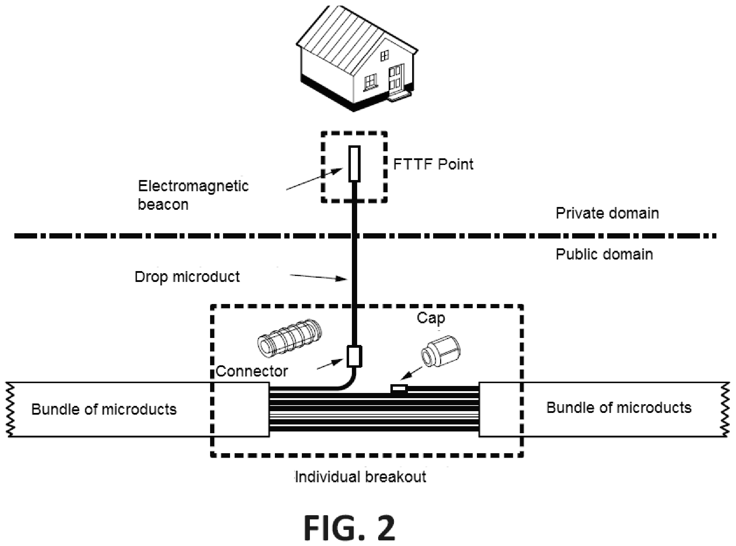

This is clearly shown in Figure 2, which illustrates a scenario where an electromagnetic beacon is used to mark the FTTF point in an individual breakout. In other words, it marks the end of a drop microduct through which the home will connect to the fiber optic network when service is to be provided to that home. For this purpose, one end of the drop microduct is connected to the corresponding microduct in the distribution network using a connector, and the other end is connected to the electromagnetic beacon (via a connector) that will signal that point. The other end of the distribution network microduct is normally closed with a cap, as shown in the figure.

The FTTF point is just one example of a "singular" point that is signaled with a beacon in a fiber optic network, but there can be many other types of network points that, for one reason or another, need to be located and, therefore, may need to be signaled with a beacon in a fiber optic network.

There are different types of location beacons for these functions. There are many types of beacons, but here we will mention only some of the most common types available on the market:

- **Ball-type beacons.** This type of beacon can usually be detected at depths of between 2 and 3 meters (depending on the manufacturer and model). They typically include a mechanism that guarantees detection accuracy, regardless of how the beacon is installed (the resonant circuit is designed to emit perpendicular to the surface, and the beacon contains the necessary means for this: self-leveling system, fluids, etc.).
- **Flat disc-type beacons.** This type of beacon can be detected at depths of between 2 and 3 meters, provided it is installed in the correct position.
- **Cylindrical type beacons.** They are cylindrical beacons that can be detected at a depth of between 2 and 3 meters if installed vertically and at a maximum depth of approximately 0.6 meters if installed horizontally (that is, they are designed to have a greater range if installed vertically).

All these locator beacons usually incorporate inside a resonant circuit (totally passive, normally a ferrite-core coil and a capacitor), which is detectable when excited by an electromagnetic signal at the appropriate frequency (usually, a different frequency is used depending on the type of buried utility). This is what a beacon detector does: it emits an electromagnetic signal at the desired resonant frequency (or within a frequency range that includes the desired resonant frequency), and the presence of a beacon is determined at the point where it detects a return signal at that frequency (originating from the beacon's resonant circuit).

Depending on the application and the circumstances of the associated project, one type of beacon may be more suitable than another. Due to their physical shape, some beacons require more space for installation than others. For this reason, the beacon with the best performance is not necessarily the most appropriate for a specific application. For example, in the case of the FTTF or HP+ points mentioned above, it is possible to use minimally invasive techniques for their implementation (for example, a drill hole made with a diameter of less than 25 mm), which allow the installation of a tip microduct from the breakout of the distribution network to the desired FTTF or HP+ point. These techniques offer many advantages in execution, as they are very quick, do not damage the ground surface (street/sidewalk/garden), and do not require soil compaction for this small installation. However, these techniques do not allow the use of ball or disc type beacons, nor vertically installed cylindrical beacons, because their size prevents them from fitting through the hole. Therefore, horizontally installed cylindrical beacons are more suitable for these applications. This occurs because the drilling is done horizontally in a trench wall (in a real-world example, the horizontal hole might be 25 mm in diameter and about 50 cm long); therefore, it's easier for a horizontal beacon, following the direction of the drop microduct, to penetrate than a vertical one. Using cylindrical beacons installed horizontally reduces the depth at which they can be detected. However, in the final sections of the network, it's common to deploy the conduits (microducts) at depths ranging from 15 cm to 60 cm (greater depths are uncommon), so this type of beacon is perfectly suitable.

There are solutions on the market for placing the beacons horizontally in accordance with the application mentioned above. There are solutions that allow these beacons to be placed at the tip of a microduct, making them ideal for installation in situations such as the one described above (FTTF or HP+ implementation using the drill boring technique). There are different versions of the same solution concept that connect the beacon to the microduct in different ways: there are models with a direct connection to the microduct (ensuring watertightness and quick attachment with standard accessories/connection means) and others with indirect connections via a rubber sleeve that allows the beacon to be attached to the microduct, which has been previously sealed with a standard cap.

The inventory and marking (so that they can be easily detected later) of points of interest in a fiber optic conduit is, therefore, clearly resolved with the materials available on the market.

But when installing a conduit (for example, for a fiber optic network), in addition to marking certain points of interest (as explained above), it is necessary to guarantee the quality of the conduit. In the case of conduit installed with microducts, three main types of tests are typically performed:

- **Continuity verification test** (also called routing verification). This is an end-to-end test that ensures the branches have been installed correctly and according to the project plans. It is common to use microducts of different colors, and during deployment there is always a risk of color confusion when creating the branches, resulting in a situation that does not match the plan (i.e., the actual routing or path of a microduct may not be correct), and therefore testing is necessary.
- **Pressure test.** This test ensures that all connections made along a routing between different microducts are watertight and meet quality standards. It also checks for permanent damage to the microducts, such as cracks or fissures.
- **Calibration test.** This test aims to ensure that the microducts in a given routing maintain a minimum internal diameter so that cables with a diameter equal to or less than the tested diameter can be installed inside them. This is a crucial test, as during civil engineering construction, the microducts may be damaged by impacts or crushing, typically due to inadequate trench preparation (covering and sand bedding, etc.) or excessive pressure during soil compaction. These impacts or crushing can reduce the available diameter inside the microduct at that point, making it impossible for the fiber optic cable to pass through, thus preventing the deployment of the fiber optic network.

For the pressure test, it is sufficient to have only one free end of the duct (microduct) into which air is introduced through the circuit until the desired pressure is reached, and measure with a manometer (at the same end) that there is no drop or loss of pressure, since the other end will be capped and it is not necessary to have access to it to verify the test. In other words, at the same end where the air is introduced, the pressure loss in the circuit is measured. However, for continuity verification testing, it has been necessary until now to have both ends of the duct open: one to introduce the air and the other to check that the air exits where it should (i.e., that the different microducts have been properly spliced without mixing). This allows verification, from the distribution point to the customer, that everything is working correctly. Furthermore, in the calibration test, a sizing gauge (such as a mandrel) is inserted into one end of the (micro)duct, requiring the other end to be open so it can be retrieved to confirm that the internal diameter is undamaged. Consequently, existing solutions also require both ends of the (micro)duct to be accessible for the calibration test.

Performing these tests is essential to verify that the conduit is correct, as any of these faults would prevent the fiber optic network from being deployed and functioning properly.

However, on the other hand, performing these tests takes a considerable amount of time and, in most cases (except for pressure testing), requires access to both ends of the pipe to be tested (essential until now in continuity and calibration tests), therefore, if there are no manholes or inspection chambers available, open holes must be made at both ends of the pipes to be tested. The possibility of keeping the holes open continuously or indefinitely is practically unfeasible for safety reasons and due to public administration permits. The possibility of opening the holes each time the tests need to be carried out may also be unfeasible due to permit issues and very costly in terms of money and time, due to the amount of work required.

For these reasons, these types of tests are typically carried out during the civil engineering work for conduit installation. The problem is that these tests slow down the pace of construction (pressure and calibration testing takes considerable time), and for this reason, many builders are reluctant to perform them completely and often only carry out some of them partially (continuity verification tests and quick pressure tests). Furthermore, even when these tests are performed partially, it is not possible to audit or repeat them meaningfully due to the difficulties explained above. Therefore, for the contractor commissioning the conduit installation, it ultimately becomes an act of faith to determine whether the conduits have been installed in perfect condition or not.

Therefore, there is a need for a technical solution that enables the minimization of both time and resource costs involved in these tests, while ensuring they are performed with high precision, as they are fundamental to the proper functioning of the conduit system.

**Summary of the invention**

The present invention serves to solve the aforementioned problems by means of a new electromagnetic beacon that not only allows the location of a fiber optic conduit to which it is connected to be indicated, but also allows continuity and pressure tests to be performed on a fiber optic conduit in an improved manner with respect to existing procedures. Normally, these fiber optic conduits will be microducts.

Thus, the present invention provides a new electromagnetic device (also called a beacon because of its signaling function), and a measurement method that, through the use of this device, enable continuity and pressure verification tests to be carried out in a conduit (also known as conduit system) of ducts (microducts), in a fast, accurate, repetitive and auditable manner.

The present invention also represents a saving of resources and time since, among other things, there is no need to have access to both ends of the conduit and, therefore, there is no need to make holes in most cases to carry out these tests (as will be explained later, to carry out the tests it is only necessary to have access to one of the ends of the conduit, which is quite common from the distribution point).

Specifically, in a first aspect of this invention, an electromagnetic device for the continuity and pressure verification on ducts of a conduit is presented. The electromagnetic device is designed to be connected at one of its ends to a duct of the conduit (for example, the device features a physical configuration at one of its ends suitable for connecting to a duct via a standard connector, or it possesses appropriate means for connection to said duct), comprising:

- A resonant circuit whose resonant frequency varies from a first frequency, $f_1$, to a second frequency, $f_2$, when the pressure in a pressure-sensitive element of the resonant circuit is greater than a predetermined first pressure threshold;

- A casing (which houses and protects the resonant circuit).

In one embodiment, the resonant circuit includes two capacitors in parallel, connected at one end to a pressure-activated switch (pressure-sensitive element) that closes when the pressure received by the switch exceeds a predetermined first pressure threshold; or where the resonant circuit includes a capacitor (pressure-sensitive element) whose capacitance changes when the pressure it receives exceeds a predetermined first pressure threshold; or where the resonant circuit includes a coil (pressure-sensitive element) whose inductance changes when the pressure it receives exceeds a predetermined first pressure threshold.

In one embodiment, when the electromagnetic device is connected to the duct, the pressure in the pressure-sensitive resonant circuit element depends on the pressure received (e.g., pressurized air) at the end of the duct to which the electromagnetic device is connected. The first predetermined pressure threshold is typically high enough that the pressure in the pressure-sensitive element (which depends on the pressure received from the duct) reaches or exceeds that threshold only when there are no leaks in the duct layout for that duct.

In one embodiment, the device comprises a first part that allows the device to be connected to the duct, wherein this first part allows air to pass to a pressure measuring chamber located between this first part and a membrane, and wherein this membrane deforms when the pressure in the chamber increases and transmits said pressure increase to the pressure-sensitive element of the resonant circuit (in this way the pressurized air that has been introduced through one end of the duct and that reaches the beacon, is transmitted to the resonant circuit so that it passes from one frequency to another).

The device may include a second part secured to the first part by a retaining system, where the diaphragm is located between the two parts (or within the second part) and where this second part is secured to the housing. The connection between the first and second parts can be made by a retaining system capable of withstanding pressures of, for example, up to 16 bar. Thus, the first and second parts, and the second part and the housing, can be joined, for example, by a retaining system such as a threaded connection or a bayonet fitting.

In one embodiment, one end of the device (the one that connects to the duct) has a cylindrical shape and an outside diameter suitable for connecting to the standard-sized duct of the conduit (e.g., via a standard duct connector).

In one embodiment, the conduit is for a fiber optic network and the duct to which the device is connected is a microduct.

In a second aspect of this invention, a method is presented for performing continuity verification tests and pressure tests on ducts of a conduit (for example, a conduit of a fiber optic network), using the device described above, wherein the method comprises:

a) Connect the electromagnetic device to one end of a duct of the conduit in a watertight manner;
b) Introduce pressurized air through the other end of the duct (the end not connected to the device, which may be located, for example, at a fiber optic network distribution point);
c) Detect the resonant frequency of the electromagnetic device;
d) If the resonant frequency has changed with respect to the resonant frequency of the device in the absence of pressurized air (i.e., it is not $f_1$ but $f_2$), then determining that the result of the test performed (continuity and/or pressure check) is positive.

In one embodiment, the duct to which the device is connected is a microduct.

In another embodiment, step c) is performed with the end of the duct connected to the electromagnetic device and the electromagnetic device buried.

In one embodiment, the pressure in the pressure-sensitive resonant circuit element depends on the pressure received by the end of the duct to which the electromagnetic device is connected, and wherein, to perform the pressure test simultaneously with the continuity verification test, a predetermined first pressure threshold is set sufficiently high (e.g., high enough that the pressure in the pressure-sensitive element reaches this threshold when there are no significant leaks in the conduit routing, specifically in the duct through which the air is introduced). This threshold might be, for example, 8 bar. If in step d) the resonant frequency has changed with respect to the resonant frequency of the device in the absence of pressurized air, then both the continuity verification test and the pressure test are deemed to be positive.

In one embodiment, prior to step a), a duct breakout is performed from a bundle of ducts in the conduit. The duct is cut, and the electromagnetic device is connected to one (cut) end of the separated duct. The end of the duct where the device is connected is the end of the duct through which a dwelling will be connected to the fiber optic network when service is to be provided to that dwelling. The method can be repeated for each separated duct in the conduit, connecting an electromagnetic device to each of the separated ducts.

In one embodiment, if in step d) the resonance frequency does not change, then the pressure at the end of the duct through which pressurized air is introduced is measured to determine whether it was a failure of the pressure test or the continuity verification test.

The scope of the present invention is defined by the appended independent and dependent claims. For a more complete understanding of the invention, its objects, and advantages, reference may be made to the following specification and the accompanying drawings.

**Brief description of the figures**

The following section briefly describes a series of drawings that help to better understand the invention and that are expressly related to an embodiment of said invention, which is presented as a non-limiting example thereof.

FIGURE 1.- Schematically shows the different sections into which an FTTH fiber optic access network can be divided.

FIGURE 2.- Schematically shows a scenario where an FTTF point is marked with an electromagnetic beacon.

FIGURE 3.- Schematically shows the connection of the beacon proposed in the present invention to one microduct, according to an embodiment of the invention.

FIGURE 4.- Schematically shows a variable resonant circuit of the beacon, whose resonant frequency varies with pressure, according to an embodiment of the invention.

FIGURE 5.- Schematically shows a scenario where the beacons proposed in the present invention are connected to three different microducts at three different points of the network, according to an embodiment of the invention.

FIGURE 6.- Shows the external shape of a beacon, according to an embodiment of the invention.

FIGURE 7.- Shows an exploded view of the proposed beacon, according to one embodiment of the invention.

FIGURE 8.- Shows a view of the resonant circuit of the proposed beacon, according to an embodiment of the invention.

FIGURE 9.- Shows a cross-sectional view of the beacon, according to an embodiment of the invention.

FIGURE 10.- Shows a view of a standard connector for connecting microducts.

**Detailed description of the invention**

Examples of embodiments of the invention are described in detail below, making reference where necessary to the figures cited above, without limiting or reducing the scope of protection of the present invention.

The electromagnetic device (beacon) proposed in the present invention is resonant at different frequencies and is connected to a microduct (or more generally to a duct) of a fiber optic conduit (also known as conduit system), so as to allow its location, as well as allowing the verification and certification of the conduits of microducts by continuity and pressure.

The beacon is designed to be connected (in one embodiment directly) to a duct, typically a micro-duct (more commonly known as a microduct), in a robust and completely airtight manner (there is no loss of pressure or airflow due to the beacon's connection to the duct). In other words, the beacon must be able to connect to the microduct (in other words, it must be connectable to the microduct). In one embodiment, the beacon will have its own means of connecting to the microduct. However, in a preferred embodiment, the beacon will have the appropriate physical shape to enable it to be connected to the (micro)duct and, in particular, will have at one of its ends the appropriate shape to allow (quick) connection to the microduct by using standard microduct connectors (as if it were a connection that provides continuity between 2 microducts). In other words, in one embodiment, the beacon at one of its ends must have the physical shape of a duct, of the same or similar diameter as the duct to which it will be connected.

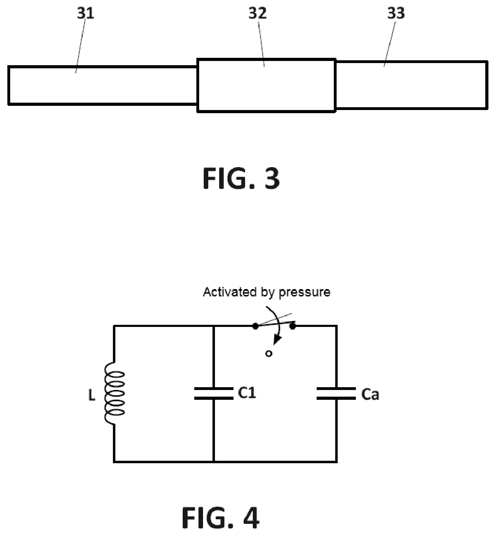

Figure 3 schematically shows the connection between a microduct (31, on the left), a connector (32, in the center) and the marker beacon that is the subject of this invention (33, on the right).

Unlike existing beacons (whose circuits resonate at a single frequency), the beacon of the present invention incorporates a variable resonant circuit that can resonate at least at two different frequencies: at rest, it resonates at a first frequency $f_1$, and when the duct to which it is connected is subjected to a pressure above a threshold ($U_1$), it resonates at a frequency $f_2$. The way in

which the frequency change is carried out may vary depending on the embodiment.

A common embodiment of a resonant circuit at a specific frequency is a basic LC circuit, a circuit consisting of a coil (also called an inductor) and a capacitor in parallel. As is known, the inductance of the coil (L) and the capacitance of the capacitor (C) define the frequency at which the circuit resonates, given by the following formula (where the frequency f is measured in hertz (Hz), the capacitance C in farads, and the inductance L in henries):

$$f = \frac{1}{2\pi\sqrt{LC}}$$

By changing the value of one of the two elements, for example the capacitor, the resonant frequency can be varied. Thus, as shown in the formulas below, changing the capacitance value of the capacitor (from $C_1$ to $C_2$, where $C_a$ is the difference between $C_2$ and $C_1$) allows us to change the resonant frequency (from $f_1$ to $f_2$).

$$f_1 = \frac{1}{2\pi\sqrt{LC_1}}$$

$$f_2 = \frac{1}{2\pi\sqrt{LC_2}}$$

$$C_2 = C_1 + C_a$$

This change in capacitor capacitance can be achieved in numerous ways. In one embodiment, for example, a push button/switch that is activated by pressure (when a pressure threshold is exceeded) can be used, adding capacitance to the resonant circuit. This is shown in Figure 4, which depicts a resonant circuit with two capacitors (with capacities $C_1$ and $C_a$, respectively) in parallel, connected by a pressure-activated switch. Below a pressure threshold ($U_1$), the switch is not activated, so the circuit's capacitance is that of the first capacitor ($C_1$), and therefore the circuit's resonant frequency is a first frequency ($f_1$). When the pressure rises above this threshold, the switch closes, so the circuit's capacitance becomes that of both capacitors ($C_1 + C_a$), and therefore the circuit's resonant frequency is a second frequency ($f_2$), different from the first. The circuit parameters (L, $C_1$, $C_a$, $U_1$) are design parameters of the device that will be chosen appropriately according to the desired operating characteristics.

Thus, for example, by conveniently choosing the circuit parameters and specifically, for example the capacitances of the capacitors to be used, it is possible to make the circuit resonate at frequencies that are commonly used in commercial beacons to signal different services (as shown in the following table).

| APPLICATION | FREQUENCY |
|---|---|
| NON-POTABLE WATER | 66.4 kHz |
| TV CABLE | 77 kHz |
| GAS | 83 kHz |
| OPTICAL FIBER | 92 kHz |
| TELEPHONE | 101.4 kHz |
| SANITARY | 121.6 kHz |
| ELECTRICITY (EURO) | 134 kHz |
| WATER | 145.7 kHz |
| ELECTRICITY | 169.8 kHz |

Thus, the first frequency $f_1$ could be the frequency used to mark buried telephone lines, 101.4 kHz, and the second frequency $f_2$ the frequency used to mark buried fiber optic lines, 92 kHz. This is just one non-limiting example, and any other frequencies could be used depending on the services to be marked, the chosen criteria... and, in general, by appropriately selecting the circuit parameters, it can resonate at the desired frequencies $f_1$ and $f_2$, depending on the application where the beacon will be used.

The pressure-activated switch/push button can be of any type. It can be any standard off-the-shelf component actuated by another system involving the movement of a stem or diaphragm, but it can also be a standard pressure switch or any device that fulfills the required function of being activated by pressure (or more generally, being pressure-sensitive).

It doesn't even have to be a pressure-activated switch/pushbutton; a capacitor whose capacitance changes with pressure would also work.

In the embodiments described above, changing the circuit's capacitance value has been used to vary the resonant frequency. However, changing the inductance value of coil L, instead of the capacitor C's capacitance, to vary the resonant frequency with pressure would also be possible and is a potential embodiment of the present invention; although, in general, it might be more complicated to manufacture. It should be noted that the resonant circuit shown in Figure 4 is only a non-limiting example of an embodiment, and the proposed beacon could include any type of resonant circuit whose resonant frequency varies with the pressure received by the circuit (or, more specifically, the pressure received or detected by one of the pressure-sensitive circuit elements).

As explained below, installing a beacon like the one described above (resonant at different frequencies depending on the pressure) allows for continuity and pressure testing of conduits in a novel and highly convenient way, both operationally and economically (due to the fact that it allows continuity and pressure verification tests to be performed without requiring both ends to be open for proper testing).

Performing pressure tests and continuity checks with currently available materials is a very costly process. There are essentially two options: perform them during the construction work or afterward.

If testing is carried out during deployment (simultaneously with the open trenches), it slows down the work pace of the civil engineering team. Furthermore, it requires more specialized personnel to perform the tests and collect and interpret the results.

If testing is done afterward, it becomes necessary to dig holes or test pits (with the significant cost this entails) to access both ends of the conduit to be tested (one end is usually accessible at the distribution point, but the other is typically buried). Leaving the holes open indefinitely throughout the deployment period is practically unfeasible.

However, with the beacon described in this invention, which changes frequency with pressure, it is possible to perform the two tests at any time, without slowing down the pace of the work and without having to open several holes afterwards to carry out the tests.

To perform the continuity verification test, with one end of the conduit available (generally, at the distribution point), it is possible to put pressure into each of the ducts independently, and with a standard detector verify (without needing to make any hole) that the duct being tested reaches the desired location (at the other end of the microduct), since, at that location and when pressure is introduced into the circuit, the resonant frequency of the beacon will change temporarily (until the pressure is removed).

In other words, if the actual duct routing is incorrect, the pressure will not reach the beacon located at the other end of the duct (for example, at point FTTF or HP+), and its resonant frequency will not change. If the actual duct routing is correct, the pressure reaches the beacon, and its resonant frequency changes. Therefore, with a beacon detector at the beacon's position (the end of the duct), continuity verification can be easily performed: if, when pressure is applied to the other end of the duct, the resonant frequency remains at the first frequency, then the continuity verification test is negative (the microduct routing is incorrect); and if, when pressure is applied to the other end of the duct, the resonant frequency changes to the second frequency, the continuity verification test is positive (the microduct routing is correct).

This method can also be used to perform the pressure test, as the beacon can be designed or calibrated to only change frequency at a sufficiently high pressure, ensuring there are no leaks along the rest of the conduit (since, if there were leaks, the correct pressure would never be reached at the beacon, and there would be no change in the resonant frequency). Therefore, if the beacon changes its resonant frequency when pressure is applied, it means the microduct connections are watertight and have no significant cracks or fissures.

Thus, whether the pressure test can be performed in conjunction with the continuity verification test will depend on the pressure threshold of the beacon, or more specifically on the pressure threshold (at the end of the duct) from which the resonant frequency of the beacon connected to the duct changes.

If this pressure threshold is low enough, for example 0.5-1 bar, then network continuity may be verified, but this would not be sufficient to guarantee network quality with the pressure test (i.e., if the beacon changes frequency, continuity could be considered verified, but the pressure test could not be guaranteed to be successful). If this threshold is sufficiently high (for example, 8 bar), then both tests could be considered passed if the beacon changes frequency (since the threshold for which the beacon was designed is sufficient to guarantee the pressure test).

In other words, if pressure is applied to one end of the duct and it is verified that the beacon (at the other end) has changed frequency, it indicates that the continuity verification test is successful, but it will only also indicate that the pressure test is successful if the pressure threshold of the beacon is high enough.

However, if pressure is applied and the beacon's frequency remains unchanged, then a continuity or pressure failure is suspected. However, it's impossible to determine which of the two (a lack of continuity or a leak in the network) is the cause. In other words, if the threshold is high enough and the beacon's frequency doesn't change, then the failure could be either related to continuity or pressure. However, in case of failure (the resonance frequency does not change), it would be possible to check if the pressure test is correct, since from the end where the pressure is introduced, the pressure could be checked (with a standard pressure gauge), and therefore determine the reason why the beacon does not activate (if the pressure gauge indicates that the pressure is correct, then it would be a continuity failure).

The use and functionality of the beacon that is the subject of the invention will now be explained with an example.

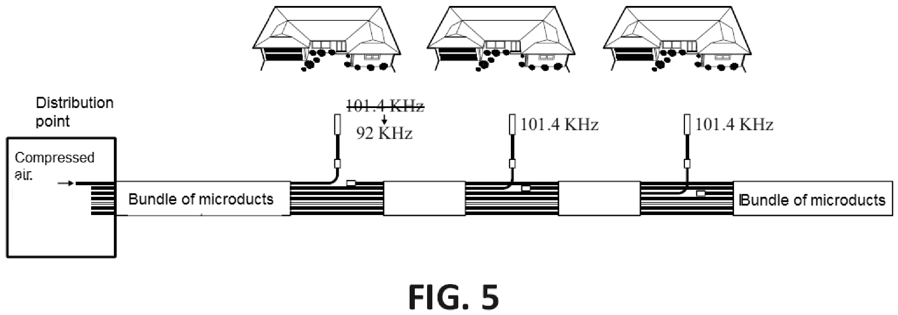

Figure 5 schematically shows a section of a distribution network that starts from the distribution point and follows the road, serving different properties or buildings (this figure shows a network diagram using only three electromagnetic beacons to mark the FTTF points of three different properties; this is a simplification, but in general, the number of beacon-marked points in a network is much greater). As can be seen, in front of each property or building, a breakout of an individual microduct is carried out and at the end of each broken-out microduct a beacon is connected to signal the breakout point. The network, except for the distribution point, is completely buried.

Or, in other words, the beacon marks the end of the drop microduct for each dwelling, through which each dwelling will connect to the fiber optic network when service is desired. To do this, each drop microduct (in the case of figure 5, the first three microducts of the microduct bundle) will be interrupted by connecting one end to an electromagnetic beacon that marks this point.

In the case shown in Figure 5, the quiescent frequency of the beacon (without applying pressure to the microduct), which is shown in figure 5, is the same and it is $f_1$ = 101.4 kHz; therefore, at all microduct ends, the beacon could be located at the frequency $f_1$ = 101.4 kHz. This allows the beacon to be located and determines where a hole should be dug to retrieve the buried microduct. However, its quiescent function does not guarantee that the microduct breakout from the main bundle has been correctly made. In this specific example in Figures 5, the other resonant frequency of the beacons is $f_2$ = 92 kHz.

The scenario shown in Figure 5 is merely a simple, non-limiting example to illustrate the present invention. Of course, the present invention can be used with a greater or lesser number of beacons, each with different resonant frequencies.

To verify that the breakouts have been performed correctly, it is necessary to apply pressure to the microduct being tested, at its end. In the case of Figure 5, pressure will be applied to the ends of the microducts located at the distribution point.

Figure 5 shows how pressure (compressed air) is applied to the first microduct in the bundle. When pressure is applied, for example, to the first microduct (the one serving the first house on the left), the frequency at which the beacon can be detected in the first house in the diagram changes from 101.4 kHz to 92 kHz. Since the beacon's resonant frequency has changed, this indicates that continuity is correct and that the pressure test is also successful.

Let's imagine that when pressure is applied to the second microduct (the one serving the second house), the frequency at which the beacon can be detected in the second house in the diagram also changes from 101.4 kHz to 92 kHz. Therefore, in this case, the continuity and pressure tests are correct. The same could happen in the third microduct (the one serving the third house).

This same procedure can be followed for each check, applying pressure to each microduct at one end and measuring the resonant frequency of the beacon at the other, ensuring that the breakout has been carried out correctly and that the network has been installed without damage (since, for the frequency to change, a pressure threshold must be exceeded, which would ensure it). If, when pressure is applied to the other end of the microduct to which the beacon is connected, the beacon's resonant frequency does not change, the test has not been passed, and therefore there has been an error in the installation of that microduct.

A beacon, according to an embodiment of the invention, is then described and presented as a non-limiting example.

In one embodiment, the electromagnetic beacon of the present invention may be composed of different elements to achieve the following desired functionalities: firstly, a resonant circuit (for example, an LC circuit) inside the beacon, which allows the resonant frequency of the circuit to change based on a certain pressure; and secondly, a watertight connection of the beacon to a duct (microduct) of the conduit network.

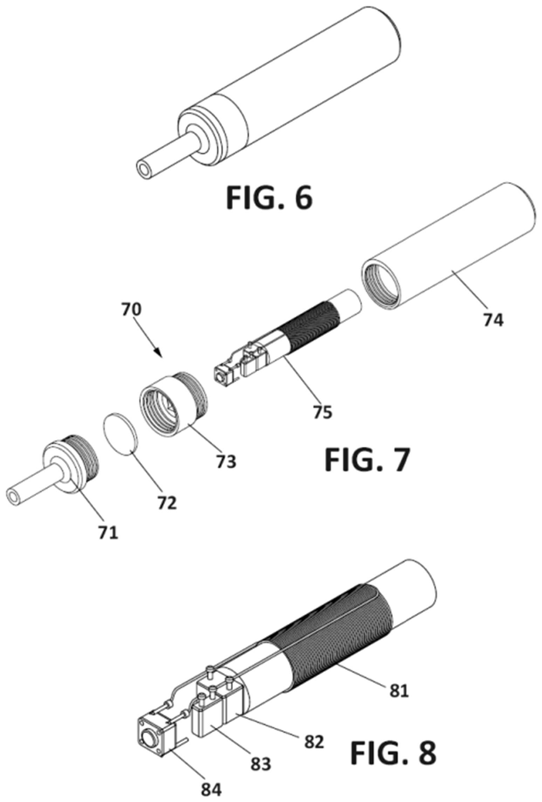

Figure 6 shows the external appearance of a tip-mounted beacon, according to one embodiment of the present invention.

Figure 7 shows an exploded view of the proposed beacon, illustrating its main components according to one embodiment of the invention.

In this embodiment, the beacon (71) would consist of the following main parts (this is only a non-limiting example, and other embodiments may contain different components and a different number of components):

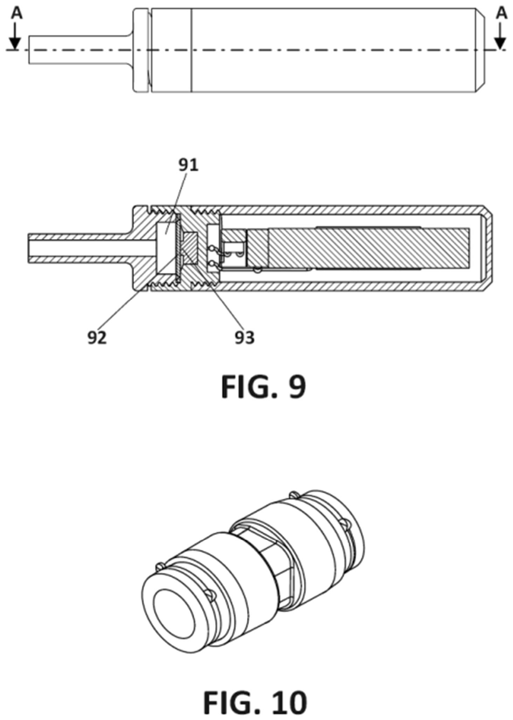

- A part (71) that allows connection to a microduct and permits the passage of air to a downstream pressure measuring chamber. This part must be suitable for coupling to a (standard) connector that connects it to the microduct. In one embodiment, this part may be cylindrical, with an outside diameter suitable for connection to a microduct of standard dimensions. In one embodiment, the connection between the beacon (specifically, this part of the beacon) and the microduct is made via a standard connector for connecting ducts (and more specifically, microducts) in a conduit. Figure 10 shows one such connector.

On the other side, this part may be adapted to the cavity or chamber where the pressure measurement will be taken. This part shall include a retention system with the next part; this could be a threaded connection, bayonet fitting, or any other system capable of withstanding sufficient pressure (for example, up to 16 bar).

- A flat gasket or membrane (72), which may be made of rubber or another elastic material, creates a watertight seal against the part that connects to the microduct and also against the next part that will hold the rest of the beacon. The space created between the first part and the rubber membrane is a pressure chamber.

- A part (73) designed to be fastened on one side by means of a threaded or crimp system (or any other known joining system) against the first part (71), and which, at this joint, exerts perimeter pressure on the elastic rubber diaphragm located between the two parts. This joint is airtight, withstanding a pressure of, for example, up to 16 bar. Between the diaphragm and this part (73) there is also a small cavity designed to allow deformation of the diaphragm when the pressure in the pressure chamber increases. In this way, the pressure that has been introduced through one end of the microduct and that reaches the beacon, deforms the membrane. This deformation activates the pressure-activated element of the resonant circuit, causing a change in the resonant circuit's frequency. In one embodiment (where the resonant circuit is of the type shown in Figure 4), the membrane deformation activates the push button located directly behind it, adding capacitance $C_a$ to the LC resonant circuit, thus changing its resonant frequency from one to another. In this embodiment (where the resonant circuit has a pressure-activated switch/push button as shown in Figure 4) this second cavity is connected to a space, which may be an orifice, where a switch/push button is positioned. This switch/push button, when it receives sufficient pressure, modifies the resonant circuit, changing it from $f_1$ to $f_2$. The push button is positioned so that its movable stem or push button is in contact with the rubber diaphragm. An increase in pressure in the pressure chamber will deform the rubber diaphragm, actuating the push button and thus modifying the resonant circuit. It can be said that this part (73) therefore provides support for both the diaphragm and the pressure switch, or, more generally, the pressure sensor of the resonant circuit.

- This part (73) is also designed to be secured with a part (74) or housing that would contain the core of the resonant circuit (75), whose resonant frequency varies with pressure (in the specific example in Figure 7, it is a two-frequency resonant circuit with a pressure switch). This housing (74) is cylindrical and designed to securely house the resonant circuit and protect it from the environment in which it will be installed (usually buried), by covering it appropriately. That is, in this embodiment (which is a non-limiting example), there would be 5 parts: 4 parts (71-74), usually plastic (although they could be made of another material), plus the resonant circuit as a whole.

This is just one non-limiting example, and in other implementations, the number of parts can be 4 or any other number (greater or less than 5). The key factor is the functionality the device provides (changing its resonant frequency when the pressure it receives through the microduct to which it's connected exceeds a certain threshold, and being able to connect to a network pipe), regardless of the number of pieces.

- Resonant circuit: As indicated, the resonant circuit could be of any type in which the resonant frequency varies when the pressure exceeds a certain threshold. In one embodiment (shown in Figure 8 and based on the resonance scheme shown in Figure 4), it can consist of: a coil (81) with inductance L, the ends of the beacon connected to a capacitor (82) with capacitance $C_1$ in parallel, another capacitor (83) with capacitance $C_a$ in series with a pressure-activated push button/switch (84); connected in parallel to the capacitor of capacitance $C_1$ and the coil L (in one embodiment, the coil could be formed by a ferrite cylinder and a wire of conductive material, copper or similar, surrounding it in the form of a loop). When the pressure rises above a certain threshold ($U_1$), the switch closes, the capacitance of the circuit changes (from $C_1$ to $C_1 + C_a$), and thus the resonant frequency varies.

Figure 9 shows a cross-sectional view of the beacon, according to one embodiment of the invention, with all its parts assembled. It can be seen how the pressure chamber (91) is located next to the diaphragm (92) so that, once pressure is applied to one end of the microduct, the pressure reaches the diaphragm, which deforms, pressing the button (93) and changing the frequency of the resonant circuit. Thus, using a device that detects the frequency of the resonant circuit, it is possible to detect from the surface (without drilling any holes) whether the continuity and pressure tests are correct (whether the resonant frequency has changed).

In summary, this text describes an electromagnetic marker device (beacon) designed to be connected (watertightly) to a duct or microduct, which incorporates inside a resonant circuit (for example an LC circuit of coil and capacitor) capable of resonating at 2 different frequencies depending on the pressure inside the duct or microduct to which the device is connected.

This device not only enables the location of the microduct to which it is connected but also allows (by following the corresponding procedure) for the verification of the correct continuity of the microducts in a conduit, without needing to have one end accessible (i.e., with one end completely buried).

It also allows performing a pressure test to verify the correct installation of a microduct network, checking that the beacon changes frequency at each point in the network where it is buried (which indicates that sufficient pressure is present at that point and, therefore, that there have been no leaks or significant damage to the conduit).

Although in many of the embodiments set out in this text, the present invention is applied in microducts of a fiber optic conduit, that is only a non-limiting example, since the present invention can be used in any type of ducts of a conduit without being limited by the dimension thereof or their use.

In this text, the word "comprises" and its variants (such as "comprising," etc.) should not be interpreted in an exclusive manner; that is, they do not preclude the possibility that what is described includes other elements, steps, etc. Likewise, in the claims, the expression "comprising" does not exclude other elements or steps, and the indefinite article "a" does not exclude a plurality. No reference symbol in the claims should be interpreted as limiting the scope.

The specific design of each element and component shown in the figures is for illustrative and example purposes only; in no case is it intended to limit the design of each component only to that shown in said figures.

The aspects defined in this detailed description are provided to aid in a thorough understanding of the invention. Accordingly, those skilled in the art will recognize that variations, changes, and modifications to the embodiments described herein may be made without departing from the scope of the invention. Likewise, descriptions of well-known functions and elements are omitted for the sake of clarity and conciseness.

Having sufficiently described the nature of the invention, as well as how to carry it out in practice, it should be noted that its different parts may be manufactured in a variety of materials, sizes and shapes, and variations may also be introduced into its constitution or procedure as practice may advise, provided that they do not alter the fundamental principle of the present invention.

**Claims**

1. Electromagnetic device (70) for verifying continuity and pressure in ducts of a conduit, wherein the electromagnetic device (70) is designed to be connected at one end to a duct of the conduit, comprising:

   - A resonant circuit (75) whose resonant frequency varies from a first frequency, $f_1$, to a second frequency, $f_2$, when the pressure in a pressure-sensitive resonant circuit element is greater than a predetermined first pressure threshold;
   - A housing (74) that houses and protects the resonant circuit (75).

2. Electromagnetic device (70) according to claim 1, wherein the resonant circuit includes two capacitors in parallel (82, 83), connected at one end to a pressure-activated switch (84), which closes when the pressure received by said switch is greater than the first predetermined pressure threshold, or wherein the resonant circuit includes a capacitor whose capacitance changes value when the pressure it receives is greater than the first predetermined pressure threshold, or wherein the resonant circuit includes a coil whose inductance changes value when the pressure it receives is greater than the first predetermined pressure threshold.

3. Electromagnetic device (70) according to any of the preceding claims, wherein when the electromagnetic device (70) is connected to the duct, the pressure in the pressure-sensitive resonant circuit element depends on the pressure received by the end of the duct to which the electromagnetic device (70) is connected.

4. Electromagnetic device (70) according to any of the preceding claims, the device (70) comprising a first part (71) that allows the device (70) to be connected to the duct, wherein this first part allows air to pass to a pressure-measuring chamber located between this first part and a membrane (72) and wherein this membrane deforms when the pressure in the chamber increases and transmits said pressure increase to the pressure-sensitive resonant circuit element.

5. Electromagnetic device (70) according to claim 4, wherein the device comprises a second part (73) attached to the first part (71) by means of a retention system, wherein the membrane (72) is located between both parts and wherein this second part (73) is attached to the housing (74).

6. Electromagnetic device (70) according to claim 5, wherein the connection between the first part (71) and the second part (73) is made by means of a retention system that allows it to withstand pressures of up to 16 bar.

7. Electromagnetic device (70) according to any of the preceding claims, wherein one of the ends of the device (70) has a cylindrical shape and an outside diameter suitable for connecting to the duct of the conduit.

8. Electromagnetic device (70) according to any of the preceding claims wherein the conduit is for an optical fiber network and the duct to which the device is connected is a microduct.

9. Method for performing continuity verification tests and pressure tests on ducts of a conduit, using the electromagnetic device described in any of the preceding claims 1-8, wherein the method comprises:

   a) Connecting the electromagnetic device (70) to one end of a duct of the conduit in a watertight manner;
   b) Introducing pressurized air through the other end, of the duct;
   c) Detecting the resonance frequency of the electromagnetic device,
   d) If the resonance frequency has changed with respect to the resonance frequency of the device in the absence of pressurized air, then determine that the result of the test performed is positive.

10. Method of claim 9, wherein the conduit is a conduit for an optical fiber network and wherein the end of the duct through which pressurized air is introduced is located at a distribution point of the optical fiber network.

11. Method of any of claims 9-10, wherein step c) is performed while the end of the duct connected to the electromagnetic device (70) and the electromagnetic device (70) itself are buried.

12. Method of any of claims 9-11, wherein the pressure in the pressure-sensitive resonant circuit element depends on the pressure at the end of the duct to which the electromagnetic device is connected, and wherein, in order to perform the pressure test at the same time as the continuity verification test, the first predetermined pressure threshold is sufficiently high so that the pressure in the pressure-sensitive element reaches that threshold when there is no leakage in the duct, and wherein, if in step d) the resonant frequency has changed with respect to the resonant frequency of the device in the absence of pressurized air, then it is determined that not only the result of the continuity verification test but also the result of the pressure test is positive.

13. Method according to any of claims 9-12, wherein the conduit is a conduit of a fiber optic network, and wherein prior to step (a), a duct is broken out from a bundle of ducts in the conduit, and the electromagnetic device is connected to one end of the broken out duct, and wherein the end of the duct to which the device (70) is connected is the end of the duct through which a dwelling will be connected to the fiber optic network when service is to be provided to said dwelling.

14. Method according to any of claims 9-13, wherein the method is repeated for each broken out duct in the conduit to which an electromagnetic device described in any of claims 1-8 has been connected.

15. Method according to any of claims 9-14, wherein if in step d) the resonance frequency does not change, then the pressure is measured at the end of the duct through which pressurized air is introduced to determine whether it was a failure of the pressure test or the continuity verification test.

FIG. 1

POINT OF PRESENCE

POINT OF DISTRIBUTION

Private Domain

FTTF POINT

FEEDER NETWORK

DISTRIBUTION NETWORK

USER ACCESS NETWORK

FIG. 2

31    32    33

**FIG. 3**

Activated by pressure

L    C1    Ca

**FIG. 4**

**FIG. 5**

**FIG. 6**

70

74

75

73

**FIG. 7**

72

71

81

82

83

84

**FIG. 8**

**FIG. 9**

**FIG. 10**

## INTERNATIONAL SEARCH REPORT

| | International application No. |
|---|---|
| | PCT/ES2023/070557 |

### A. CLASSIFICATION OF SUBJECT MATTER

*G01R31/08* (2020.01)
*G01R31/50* (2020.01)
According to International Patent Classification (IPC) or to both national classification and IPC

### B. FIELDS SEARCHED

Minimum documentation searched (classification system followed by classification symbols)
G01R, G01S

Documentation searched other than minimum documentation to the extent that such documents are included in the fields searched

Electronic data base consulted during the international search (name of data base and, where practicable, search terms used)

EPODOC, INVENES, WPI, INSPEC, XPAIP, XPESP, XPI3E, XPI3ES, XPIEE, XPMISC, XPOAC

### C. DOCUMENTS CONSIDERED TO BE RELEVANT

| Category* | Citation of document, with indication, where appropriate, of the relevant passages | Relevant to claim No. |
|---|---|---|
| X | US 4862088 A (NOLF, JEAN-MARIE E. ET AL.) 29/08/1989, abstract; column 1, lines 6 - 39; column 2, lines 18 - 65; column 5, lines 16 - 36; column 6, line 39 - column 7, line 39; column 8, line 45 - column 9, line 13; column 11, lines 45 - 58; column 14, lines 8 - 25; figure 2, figure 6, figure 13, figure 19; claims 1-2; claim 29. | 1-15 |
| A | HOPSTER, J.: "Pruebas of presión in una canalización of fibra óptica". Esders, 31/01/22 [on line][retrieved the 22/05/2024]. Retrieved from <URL: https://www.esders.es/2022/01/pruebas-presion-canalizacion-fibra-optica/>. | 1-15 |

☐ Further documents are listed in the continuation of Box C.   ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means. | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | |
| | "&" document member of the same patent family |

| Date of the actual completion of the international search | Date of mailing of the international search report |
|---|---|
| 22/05/2024 | **(27/05/2024)** |

| Name and mailing address of the ISA/ | Authorized officer |
|---|---|
| | E. Pina Martínez |
| OFICINA ESPAÑOLA DE PATENTES Y MARCAS Paseo de la Castellana, 75 - 28071 Madrid (España) Facsimile No.: 91 349 53 04 | Telephone No. 913498552 |

Form PCT/ISA/210 (second sheet) (July 2022)

## INTERNATIONAL SEARCH REPORT

Information on patent family members

International application No.

PCT/ES2023/070557

| Patent document cited in the search report | Publication date | Patent family member(s) | Publication date |
|---|---|---|---|
| US4862088 A | 29.08.1989 | JPS6195257 A | 14.05.1986 |
| | | EP0182488 A1 | 28.05.1986 |
| | | EP0182488 B1 | 05.09.1990 |
| | | CA1269547 A | 29.05.1990 |
| | | ATE56279T T1 | 15.09.1990 |

Form PCT/ISA/210 (patent family annex) (July 2022)